# FASCICULE DE BREVET EUROPEEN

(11) **EP 1 652 216 B1**
(45) Date de publication et mention de la délivrance du brevet: **19.10.2011**
(21) Numéro de dépôt: 04766322.4
(22) Date de dépôt: 27.07.2004
(51) Int. Cl.: H01L 21/673

(54) **SUPPORT DE PLAQUETTES, CONVERTIBLE POUVANT RECEVOIR AU MOINS DEUX TYPES DE PLAQUETTES DIFFERENCIES PAR LA DIMENSION DES PLAQUETTES**
UMKONFIGURIERBARE PAD-HALTERUNG ZUR AUFNAHME MINDESTENS ZWEIER PADS VERSCHIEDENER ABMESSUNGEN
CONVERTIBLE PAD SUPPORT FOR RECEIVING AT LEAST TWO PADS OF DIFFERENT DIMENSIONS

(30) Priorité: 28.07.2003 FR 0309253
(43) Date de publication de la demande: 03.05.2006
(73) Titulaire: Semco Engineering S.A., 34196 Montpellier cedex 5 (FR)
(72) Inventeur: PELLEGRIN, Yvon, F-34000 MONTPELLIER (FR)
(74) Mandataire: Ravina, Bernard
(86) Numéro de dépôt international: PCT/EP2004/051612
(87) Numéro de publication internationale: WO 2005/015612

(56) Documents cités:
- DE-A- 4 300 205
- US-A- 4 858 764
- PATENT ABSTRACTS OF JAPAN vol. 1999, no. 12, 29 octobre 1999 (1999-10-29) -& JP 11 176917 A (TOKIN CORP), 2 juillet 1999 (1999-07-02)
- PATENT ABSTRACTS OF JAPAN vol. 1997, no. 04, 30 avril 1997 (1997-04-30) -& JP 08 330406 A (FUKUI SHINETSU SEKIEI:KK; SHINETSU QUARTZ PROD CO LTD), 13 décembre 1996 (1996-12-13)

## Description

La présente invention se rapporte à un support de plaquettes de silicium à 45° destiné au maintien à écartement constant les unes des autres de plusieurs plaquettes de silicium, ledit support étant convertible afin de recevoir des plaquettes de silicium de tailles différentes.

Les supports de plaquettes connus, comprennent plusieurs bras parallèles, longiformes, fixés rigidement par leurs extrémités à deux flancs latéraux s'étendant de manière perpendiculaire par rapport à l'axe longitudinal de chaque bras. Les bras sont pourvus à intervalle régulier d'encoches. Les plaquettes sont glissées et logées par leur périphérie, dans ces encoches. Typiquement ces supports sont équipés de quatre ou cinq bras.

Les supports tels que décrits sont conçus pour ne recevoir qu'une seule taille de plaquettes de sorte que les fabricants, pour répondre à toutes les attentes de leurs clients se voient contraints de tenir un parc important de support.

Par exemple les cellules solaires de forme carrée sont disponibles en deux dimensions à savoir 125 mm et 150 mm. Le fabricant pour couvrir ces deux types fabrications devra être équipé de supports adaptés aux plaquettes de 125 mm et de supports adaptés aux plaquettes de 150 mm.

On connaît aussi des supports qui peuvent recevoir des plaquettes de tailles différentes. De tels support sont décrits dans la demande de brevet JP 11 176917 et dans le brevet US 4 858 764.

La présente invention a pour objet un support pour plaquettes qui par simple manipulation peut être adapté soit à la réception de plaquettes d'une première taille soit à la réception de plaquettes d'une seconde taille.

À cet effet le support de plaquettes, convertible, pouvant recevoir au moins deux types de plaquettes différenciés par la dimension des plaquettes, constitué par une structure tridimensionnelle délimitant un volume de rangement dans lequel sont positionnées les plaquettes, ledit volume possédant un axe géométrique central longitudinal contenu dans un plan géométrique P médian longitudinal de ladite structure, laquelle structure comporte deux flancs latéraux (3) perpendiculaires à l'axe géométrique central, et au moins deux bras fixes, parallèles au dit axe géométriques central, fixés rigidement aux deux flancs latéraux et dotés d'encoches tournées vers le volume de rangement, et les différentes encoches étant agencées selon des plans géométriques successifs, parallèles, à écartement constant les uns des autres, et perpendiculaires à l'axe central longitudinal du volume de rangement, ledit support étant de plus doté d'au moins un bras additionnel, parallèle à l'axe géométrique AA' du volume de rangement ledit bras étant doté d'encoches tournées vers ledit volume de rangement, ledit bras additionnel coopérant en fixation avec la structure tridimensionnelle et étant prévu pour être positionné en regard du volume de rangement et assurer, en combinaison avec les autres bras le maintien des plaquettes dans le volume de rangement, la distance normale entre ce bras additionnel et l'axe géométrique longitudinal de l'un quelconque bras fixe étant ajustable afin d'adapter ledit support aux dimensions des plaquettes à recevoir, et ledit bras étant fixé de manière amovible à la structure et que l'un des deux éléments, structure ou bras additionnel, comporte au moins deux premières paires d'organes de fixation, les organes de chaque premières paires étant distants l'un de l'autre et alignés selon un axe géométrique de fixation, parallèle à l'axe géométrique central longitudinal AA' du volume de rangement, la distance normale entre l'axe géométrique de fixation de chaque paire d'organes de fixation et l'axe géométrique longitudinal de l'un quelconque bras fixe étant différente d'une paire d'organes de fixation à l'autre, et que l'autre élément, bras additionnel ou structure, comporte au moins une deuxième paire d'organes de fixation distants l'un de l'autre et alignés selon un autre axe géométrique de fixation parallèle à l'axe géométrique central longitudinal (AA') du volume de rangement, les organes de fixation de ladite deuxième paire étant les conjugués des organes de fixation des deux premières paires et ladite deuxième paire d'organes de fixation étant prévue pour coopérer en fixation avec l'une ou l'autre des deux premières paires d'organes de fixation afin d'adapter ledit support aux dimensions des plaquettes à recevoir, **caractérisé en ce que** les deux premières paires d'organes de fixation sont ménagées sur les flancs latéraux de la structure (1), que chaque flanc latéral comporte l'un des organes de fixation des deux premières paires d'organes de fixation et que le bras additionnel, perpendiculairement à son axe longitudinal, comprend deux pattes latérales, élastiquement déformables, portant à distance dudit bras les organes de fixation de la seconde paire d'organes de fixation.

Ainsi un même support peut recevoir des lots de plaquettes différenciés par la dimension de ces dernières ce qui réduit de manière conséquente le nombre de support que doit posséder le fabriquant pour répondre aux différents besoins.

Par ailleurs, l'adaptation du support selon l'invention s'effectue d'une manière simple et rapide.

Selon une autre caractéristique de l'invention, le bras additionnel est fixé à la structure de manière pivotante en éloignement ou rapprochement angulaire du plan géométrique médian longitudinal de ladite structure, ledit bras par pivotement angulaire vers le plan médian étant replié vers le volume de rangement.

Le bras additionnel, par pivotement peut être positionné latéralement au volume de rangement et laisser libre le passage à un lot de plaquettes qui peut ainsi être introduit ou retiré du support par mouvement selon un axe un axe normal à l'axe longitudinal du volume de rangement et contenu dans le plan géométrique médian de ce volume. Ainsi les moyens pour introduire ou retirer le lot de plaquettes dans ou du support seront plus simples sachant que l'introduction ou le retrait pour les supports actuels s'effectuent selon une direction oblique par rapport au plan médian ce qui conduit à complexifier les moyens d'introduction ou de retrait.

Selon une autre caractéristique de l'invention, les bras fixes de la structure sont encastrés dans les flancs latéraux de cette dernière. Une liaison par encastrement assure une bonne rigidité grâce à quoi il est possible d'utiliser des bras de longueurs relativement importantes et de produire des supports de plus grande capacité.

Selon une forme caractéristique de l'invention, le support comprend d'une part une structure comportant quatre bras fixes disposés selon les arêtes longitudinales d'un prisme de section droite en trapèze isocèle et d'autre part un bras additionnel mobile et/ou amovible.

D'autres avantages et caractéristiques de l'invention apparaîtront à la lecture de la description d'une forme préférée de réalisation donnée à titre d'exemple purement indicatif en se référant aux dessins annexés en lesquels :
- la figure 1 est une vue en perspective d'un support selon l'invention, configuré pour recevoir des plaquettes d'une première classe dimensionnelle, le bras additionnel étant en position repliée,
- la figure 2 est une vue en perspective du support selon la figure 1, le bras additionnel étant en position écartée,
- la figure 3 est une vue en perspective d'un support selon l'invention, configuré pour recevoir des plaquettes d'une seconde classe dimensionnelle, le bras additionnel étant en position repliée,
- la figure 4 est une vue en perspective du support selon la figure 3, le bras additionnel étant en position écartée,

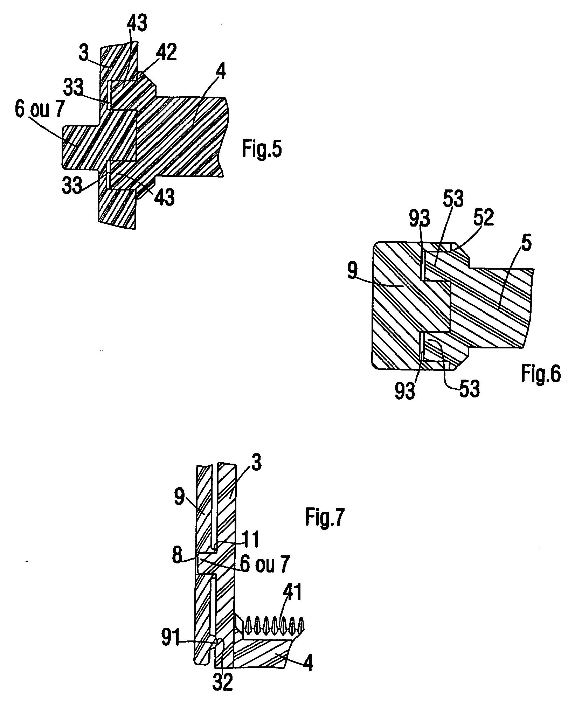

- les figures 5 à 7 sont des vues en coupe de détail du support selon l'invention.

Tel que représenté, le support convertible selon l'invention, peut recevoir deux types de plaquettes de silicium 2 de forme carrée, différenciés par la dimension des côtés des plaquettes. Ces plaquettes 2 pourront être destinées, après traitement approprié, à constituer par exemple des cellules photovoltaïques ou autre.

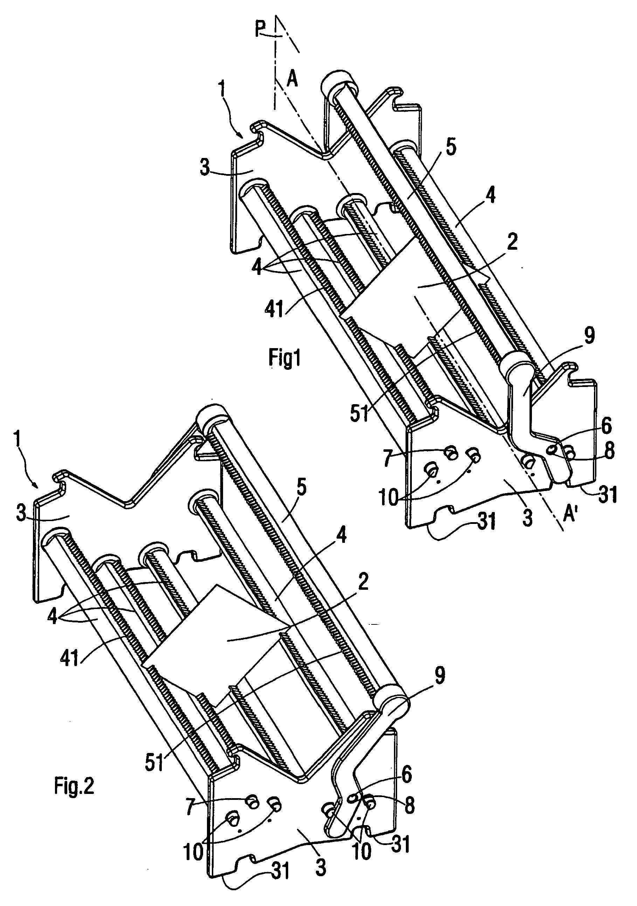

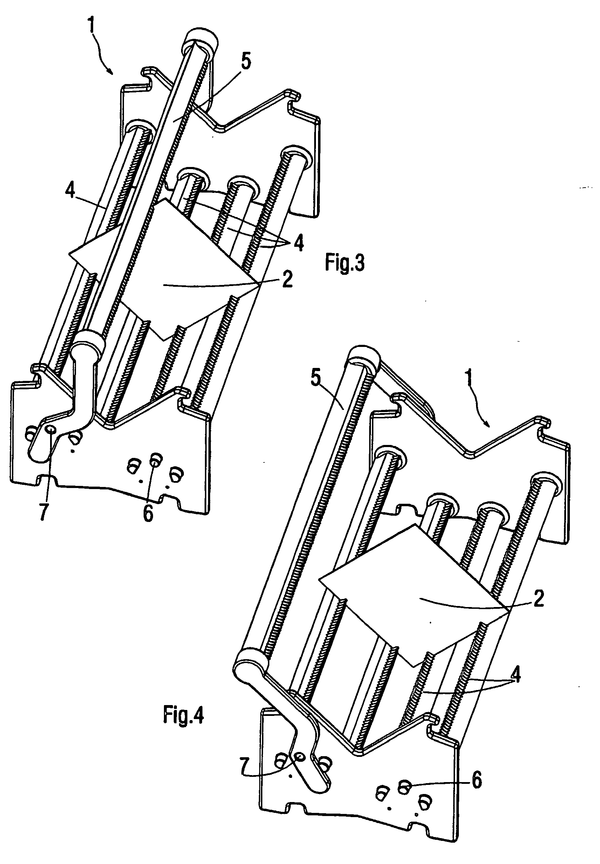

En figure 1 à 4 n'a été représentée qu'une seule plaquette 2 pour des raisons de simplification des dessins et de lisibilité de ces derniers. II est bien évident que le support est prévu pour recevoir un lot de plusieurs plaquettes.

Le support convertible est constitué par une structure tridimensionnelle 1 délimitant un volume de rangement dans lequel sont positionnées les plaquettes 2, ledit volume possédant un axe géométrique central longitudinal AA' contenu dans un plan géométrique P médian longitudinal de ladite structure.

La structure 1 comporte deux flancs latéraux 3 perpendiculaires à l'axe géométrique central AA', et quatre bras fixes 4, parallèles au dit axe géométrique central, fixés rigidement aux deux flancs latéraux 3 et dotés d'encoches 41 tournées vers le volume de rangement, et agencées selon des plans géométriques successifs, parallèles, à écartement constant les uns des autres, et perpendiculaires à l'axe central longitudinal AA' du volume de rangement.

Conformément à l'invention, le support convertible est doté d'au moins un bras additionnel 5 parallèle à l'axe géométrique du volume de rangement et doté d'encoches 51, tournées vers ledit volume de rangement. Ce bras additionnel 5 coopère en fixation avec la structure tridimensionnelle 1 et est destiné être positionné en regard du volume de rangement pour assurer en combinaison avec les autres bras, le maintien des plaquettes 2 dans le volume de rangement. La distance normale entre ce bras additionnel 5 et l'axe géométrique de l'un quelconque bras fixe est ajustable afin d'adapter le support aux dimensions des plaquettes 2 à recevoir. Le bras additionnel 5 est ajustable en position.

Les quatre bras fixes 4, sont préférentiellement disposés selon les arêtes longitudinales d'un prisme droit de section droite en trapèze isocèle, le plan médian longitudinal du volume de rangement constituant plan de symétrie de ce prisme. Les bases de ce prisme sont occupées par les deux flancs latéraux 3.

La structure 1, perpendiculairement au plan de symétrie P tel que défini, présente deux faces planes d'appui et de positionnement 31, coplanaires, respectivement formées sur les deux flancs latéraux 3. Ces faces d'appui et de positionnement 31 sont en fait constituées par les rives inférieures horizontales des deux flancs latéraux 3.

La face du prisme droit correspondant à la petite base du trapèze isocèle que forme la section droite est tournée vers le bas.

Les quatre bras fixes 4 forment en fait un berceau dans lequel sont positionnées les plaquettes 2. Chaque plaquette 2 repose sur les quatre bras par deux côtés contigus et le bras additionnel 5 vient en appui contre l'un des deux autres côtés de la plaquette. Cette disposition à cinq bras permet le positionnement à la verticale du support convertible. Selon cette position, les plaquettes sont horizontales. Le support assure un positionnement des plaquettes à 45°

Par les deux faces d'appui 31, le support peut être positionné sur des plateformes horizontales de chargement de et de déchargement de plaquettes que possèdent généralement les machines de transfert.

Les quatre bras fixes 4 de la structure tridimensionnelle sont fixés par encastrement aux flancs latéraux 3. Selon la forme préférée de réalisation, chaque bras fixe 4, à chaque extrémité comporte une platine 42, pourvue de plusieurs pions cylindriques saillants 43. À titre d'exemple seront prévus quatre pions saillants régulièrement répartis selon un cercle.

Les pions saillants 43 des différents bras fixes 4 sont destinés à être encastrés dans des perçages borgnes 33 pratiqués dans les flancs latéraux 3 de la structure 1.

La fixation des pions 43 dans les perçages correspondants sera opérée par soudage par ultrasons ou par collage ou autres moyens et techniques. Par ailleurs chaque platine 42 présente une face d'appui contre la face interne au volume de rangement, du flanc latéral correspondant. Cette caractéristique, en combinaison avec l'encastrement des pions assure une excellente rigidité en flexion de la liaison du bras 4 au flanc 3 correspondant grâce à quoi il est possible de prévoir des bras 4 de longueurs accrues sans risque de déformation de la structure 1. Une structure 1 qui présente des bras de longueur accrue, confère au support une plus grande contenance.

Le bras 5 ajustable en position est fixé de manière amovible à la structure 1 et l'un des deux éléments, structure 1 ou bras additionnel 5, comporte au moins deux premières paires d'organes de fixation 6, 7, les organes 6, 7 de chaque premières paires étant distants l'un de l'autre et alignés selon un axe géométrique de fixation, parallèle à l'axe géométrique central longitudinal AA' du volume de rangement.

La distance normale entre l'axe géométrique de fixation de chaque paire d'organes de fixation 6, 7 et l'axe géométrique longitudinal de l'un quelconque bras fixe 4 est différente d'une paire d'organes de fixation à l'autre. D'une autre manière, la distance normale entre l'axe géométrique de fixation et les faces planes d'appui 31 est différente d'une paire à l'autre.

L'autre élément, bras additionnel 5 ou structure 1, comporte au moins une deuxième paire d'organes de fixation 8, distants l'un de l'autre et alignés selon un autre axe géométrique de fixation parallèle à l'axe géométrique central longitudinal AA' du volume de rangement, les organes de fixation 8 de ladite deuxième paire étant les conjugués des organes de fixation 6, 7 des deux premières paires et ladite deuxième paire d'organes de fixation étant prévue pour coopérer en fixation avec l'une ou l'autre des deux premières paires d'organes de fixation 6, 7 afin d'adapter le support 1 aux dimensions des plaquettes 2 à recevoir.

Selon la forme préférée de réalisation, les deux premières paires d'organes de fixation 6, 7 sont ménagées sur les flancs latéraux 3 de la structure 1, chaque flanc latéral comportant l'un des organes de fixation des deux premières paires d'organes de fixation et le bras additionnel 5, perpendiculairement à son axe longitudinal, comprend deux pattes latérales 9, élastiquement déformables, portant à distance dudit bras 5, les organes de fixation 8 de la seconde paire d'organes de fixation.

Les pattes latérales seront fixées aux extrémités du bras additionnel 5 par encastrement. À cet effet, le bras additionnel 5, tout comme les bras fixes 4, comporte à chaque extrémité une platine 52 pourvue de plusieurs pions cylindriques saillants 53 prévus pour être encastrés dans des perçages borgnes 93 pratiqués dans la patte élastique correspondante.

La fixation des pions 53 dans les perçages 93 sera effectuée par soudage par ultrason, par collage ou autres moyens et techniques.

Par ailleurs chaque platine 52 présente une face d'appui contre la patte flexible correspondante. Cette caractéristique, en combinaison avec l'encastrement des pions 53 assure une excellente rigidité en flexion de la liaison du bras 5 aux pattes flexibles 9.

Les deux premières paires d'organes de fixation 6, 7 sont ménagées sur les grandes faces externes au volume de rangement des deux flancs latéraux 3 et les pattes latérales 9 du bras additionnel 5 viennent en regard de ces deux grandes faces. Selon la forme préférée de réalisation, chaque organe de fixation 6, 7 des deux premières paires d'organes de fixation 6, 7 est constitué par un bossage et l'organe de fixation 8 dont est dotée chaque patte latérale 9 est constitué par alésage prévu pour coopérer en emboîtement de forme avec le bossage correspondant.

L'adaptation du support à une taille donnée de plaquettes à traiter s'effectue par changement de la position du bras additionnel 5, ce dernier étant dégagé de la paire coopérante d'organes de fixation 6 ou 7 pour être engagé sur l'autre paire.

Comme on le conçoit, l'opération est relativement simple, aisée et rapide à accomplir puisqu'il suffit d'abord d'écarter les pattes élastiques 9 et de dégager les organes de fixation 8 des organes 6 ou 7 de la paire coopérante, et ensuite d'engager ces organes de fixation 8 sur les organes de fixation 7 ou 6 de l'autre première paire d'organes de fixation.

Selon la forme préférée de réalisation, en considérant le plan médian longitudinal AA', les organes de fixation 7 sont d'un côté de ce plan tandis que les autres organes de fixation 6 de l'autre côté. Pour cette raison, lors de son changement de position, le bras 5 sera pivoté sur lui-même afin que les encoches 51 dont il est doté soient toujours positionnées en regard du volume de rangement.

Préférentiellement, le bras additionnel 5 est fixé à la structure 1 de manière pivotante en éloignement ou rapprochement angulaire du plan géométrique médian longitudinal. Le bras additionnel peut ainsi être rabattu vers le volume de rangement en vue du maintien dans ce dernier, du lot de plaquettes qui s'y trouve ou bien être écarté latéralement de ce volume en vue de permettre soit le retrait du lot de plaquettes ou l'introduction d'un nouveau lot selon une direction normale aux faces d'appui 31. Pour la mise en oeuvre d'une telle caractéristique, les organes de fixation 6 et 7 seront de formes cylindriques et formeront des tourillons et les organes de fixation 8 se présenteront sous la forme d'alésage cylindrique.

L'amplitude du mouvement de pivotement du bras additionnel est limitée par des butées 10 fixées à la structure. Plus précisément, ces butées sont constituées par des bossages formant saillies sur les faces externes, au volume de rangement, des deux flancs latéraux 3. Préférentiellement, à chaque organe 6 ou 7 sont associées deux butées 10.

Selon une forme préférée de réalisation, chaque patte latérale 9 du bras additionnel 5 comprend deux tronçons rectilignes parallèles décalés latéralement l'un par rapport et joint l'un à l'autre par une forme de coude, le tronçon rectiligne enraciné au bras 5 étant décalé vers le plan médian longitudinal de la structure. Cette disposition est propice à faciliter notamment le mouvement de repliement du bras 5 sur le volume de rangement.

Préférentiellement, les positions de repliement et de dégagement du bras additionnel 5 sont indexées. À cet effet chaque patte latérale 9 du bras additionnel comporte en saillie sur celle de ses deux faces venant en regard du flanc latéral 3, un bossage 91 en calotte sphérique et chaque flanc latéral est doté d'empreintes en calotte sphérique 32, prévues pour recevoir le bossage.

Préférentiellement chaque patte latérale 9 du bras additionnel 5 prend appui contre le flanc latéral 3 correspondant par l'intermédiaire d'un bossage longiforme 11 assurant un contact linéaire. Ce bossage longiforme 11 pourra se développer selon un arc de circonférence de cercle. Cette disposition qui à pour but de maintenir les deux pattes élastiques 9 à distance des flancs latéraux 3 à pour but de faciliter l'écoulement des liquides de rinçage et d'éviter toute accumulation de ce dernier entre deux surfaces en contact. On réduit ainsi le risque de pollution des bains de traitement par ces liquides de rinçage ou lavage.

II va de soi que la présente invention peut recevoir tous aménagements et variantes du domaine des équivalents techniques sans pour autant sortir du cadre du présent brevet.

## Revendications

1. Support de plaquettes, convertible, pouvant recevoir au moins deux types de plaquettes (2) différenciés par la dimension des plaquettes, constitué par une structure tridimensionnelle (1) délimitant un volume de rangement dans lequel sont positionnées les plaquettes (2), ledit volume possédant un axe géométrique central longitudinal (AA') contenu dans un plan géométrique P médian longitudinal de ladite structure, laquelle structure comporte deux flancs latéraux (3) perpendiculaires à l'axe géométrique central, et au moins deux bras fixes (4), parallèles au dit axe géométrique central (AA'), fixés rigidement aux deux flancs latéraux (3) et dotés d'encoches (41) tournées vers le volume de rangement, et les différentes encoches (41) étant agencées selon des plans géométriques successifs, parallèles, à écartement constant les uns des autres, et perpendiculaires à l'axe central longitudinal du volume de rangement, ledit support_étant de plus doté d'au moins un bras additionnel (5), parallèle à l'axe géométrique (AA') du volume de rangement ledit bras étant doté d'encoches (51) tournées vers ledit volume de rangement, ledit bras additionnel (5) coopérant en fixation avec la structure (1) tridimensionnelle et étant prévu pour être positionné en regard du volume de rangement et assurer, en combinaison avec les autres bras (4) le maintien des plaquettes dans le volume de rangement, la distance normale entre ce bras additionnel (5) et l'axe géométrique longitudinal de l'un quelconque bras fixe (4) étant ajustable afin d'adapter ledit support aux dimensions des plaquettes (2) à recevoir, et ledit bras (5) étant fixé de manière amovible à la structure (1) et que la structure (1), comporte au moins deux premières paires d'organes de fixation (6, 7), les organes de chaque premières paires étant distants l'un de l'autre et alignés selon un axe géométrique de fixation, parallèle à l'axe géométrique central longitudinal (AA') du volume de rangement, la distance normale entre l'axe géométrique de fixation de chaque paire d'organes de fixation (6, 7) et l'axe géométrique longitudinal de l'un quelconque bras fixe (4) étant différente d'une paire d'organes de fixation à l'autre, et que le bras additionnel (5), comporte au moins une deuxième paire d'organes de fixation (8) distants l'un de l'autre et alignés selon un autre axe géométrique de fixation parallèle à l'axe géométrique central longitudinal (AA') du volume de rangement, les organes de fixation (8) de ladite deuxième paire étant les conjugués des organes de fixation (6,7) des deux premières paires et ladite deuxième paire d'organes de fixation (8) étant prévue pour coopérer en fixation avec l'une ou l'autre des deux premières paires d'organes de fixation (6, 7)afin d'adapter ledit support aux dimensions des plaquettes (2) à recevoir, les deux premières paires d'organes de fixation (6, 7) étant ménagées sur les flancs latéraux (3) de la structure (1), que chaque flanc latéral (3) comportant un des organes de fixation (6, 7) des deux premières paires d'organes de fixation **caractérisé en ce que** le bras additionnel (5), perpendiculairement à son axe longitudinal, comprend deux pattes latérales (9), élastiquement déformables, portant à distance dudit bras (5) les organes de fixation de la seconde paire d'organes de fixation (8).

2. Support convertible selon la revendication 1, **caractérisé en ce que** les deux premières paires d'organes de fixation (6, 7) sont ménagées sur les grandes faces externes au volume de rangement, des deux flancs latéraux (3) et que les pattes latérales (9) du bras additionnel (5) viennent en regard de ces deux grandes faces.

3. Support convertible selon la revendication 1 ou la revendication 2, caractérisé en ce chaque organe de fixation des deux premières paires d'organes de fixation 6, 7 est constitué par un bossage et que l'organe de fixation (8) dont est dotée chaque patte latérale est constitué par un alésage prévu pour coopérer en emboîtement de forme avec le bossage correspondant (6) ou (7) correspondant.

4. Support convertible selon l'une quelconque des revendications précédentes, **caractérisé en ce que** le bras additionnel (5) est fixé à la structure (1) de manière pivotante en éloignement ou rapprochement angulaire du plan géométrique médian longitudinal (P) de ladite structure, ledit bras (5), par pivotement angulaire vers le plan médian (P) étant replié vers le volume de rangement.

5. Support convertible selon la revendication 4, **caractérisé en ce que** l'amplitude du mouvement de pivotement du bras (5) est limitée par des butées (10) fixées à la structure (1).

6. Support convertible selon l'une quelconque des revendications précédentes, **caractérisé en ce que** les pattes latérales (9) du bras additionnel (5) comprend deux tronçons rectilignes parallèles décalés latéralement l'un par rapport et joint l'un à l'autre par une forme de coude, le tronçon rectiligne enraciné au bras (5) étant décalé vers le plan médian longitudinal (P) de la structure.

7. Support convertible selon l'une quelconque des revendications précédentes, **caractérisé en ce que** chaque patte latérale (9) du bras (5) prend appui contre le flanc latéral (3) correspondant par l'intermédiaire d'un bossage longiforme (11) assurant un contact linéaire.

8. Support convertible selon l'une quelconque des revendications précédentes, **caractérisé en ce que** les bras fixes (4) de la structure (1) sont encastrés dans les flancs latéraux (3) de cette dernière.

9. Support convertible selon l'une quelconque des revendications précédentes, **caractérisé en ce qu'**il comprend d'une part une structure (1) comportant quatre bras fixes (4) disposés selon les arêtes longitudinales d'un prisme de section droite en trapèze isocèle et d'autre part un bras additionnel (5).

## Claims

1. Convertible pad support that can receive at least two types of pad (2) of different dimensions, consisting of a three-dimensional structure (1) defining a storage volume in which the pads (2) are positioned, said volume having a longitudinal central geometric axis (AA') contained in a longitudinal median geometric plane P of said structure, which structure includes two lateral flanks (3) perpendicular to the central geometric axis, and at least two fixed arms parallel to said central geometric axis (AA') rigidly attached to the two lateral flanks (3) and provided with notches (41) turned toward the storage volume, and the different notches (41) being arranged in successive geometric planes, parallel, evenly spaced, and perpendicular to the longitudinal central axis of the storage volume, said support also being fitted with at least one additional arm (5) parallel to the geometric axis (AA') of the storage volume, said arm being provided with notches (51) turned towards said storage volume, said additional arm (5) cooperating in a fastening action with the three-dimensional structure (1) and being designed to be positioned facing the storage volume and, in combination with the other arms (4), to hold the pads in the storage volume, the normal distance between this additional arm (5) and the longitudinal geometric axis of any of the fixed arms (4) being adjustable so as to adapt said support to the dimensions of the pads (2) to be housed, and said arm (5) being attached in a removable manner to the structure (1) and that the structure (1) includes at least two first pairs of fastening components (6, 7), the components of each first pair being at a distance from each other and aligned according to a geometric fastening axis parallel to the longitudinal central geometric axis (AA') of the storage volume, the normal distance between the geometric fastening axis of each pair of fastening components (6, 7) and the longitudinal geometric axis of any one of the fixed arms (4) being different from one pair of fastening components to the next, and that the additional arm (5) includes at least a second pair of fastening components (8) distant from one another and aligned along another geometric fastening axis parallel to the longitudinal central geometric axis (AA') of the storage volume, the fastening components (8) of said second pair being the combinations of the fastening components (6, 7) of the first two pairs and said second pair of fastening components (8) being designed to cooperate in a fastening action with one or the other of the first two pairs of fastening components (6, 7) in order to adapt said support to the dimensions of the pads (2) to be housed, the first two pairs of fastening components (6, 7) being installed on the lateral flanks (3) of the structure (1), each lateral flank (3) including one of the fastening components (6, 7) of the first two pairs of fastening components **characterized in that** the additional arm (5), perpendicular to its longitudinal axis, includes two lateral lugs (9), subject to elastic deformation, bearing at a distance from said arm (5) the fastening components of the second pair of fastening components.

2. Convertible support according to claim 1, **characterized in that** the first two pairs of fastening components (6, 7) are installed on the large faces external to the storage volume of the two lateral flanks (3) and that the lateral lugs (9) of the additional arm (5) face these two large faces.

3. Convertible support according to claim 1 or claim 2, **characterized in that** each fastening component of the first two pairs of fastening components 6, 7 consists of a boss, and that the fastening component (8) with which each lateral lug is equipped consists of a bore designed to cooperate in a socket-fitting action with the corresponding boss (6) or (7).

4. Convertible support according to any of the claims above, **characterized in that** the additional arm (5) is attached to the structure (1) in a swiveling manner, with an angular push-out/pull-in action in relation to the longitudinal median geometric plane (P) of said structure, said arm (5) through angular swiveling toward the median plane (P) being bent back toward the storage volume.

5. Convertible support according to claim 4, **characterized in that** the amplitude of the swiveling motion of the arm (5) is limited by thrusts (10) attached to the structure (1).

6. Convertible support according to any of the claims above, **characterized in that** the lateral lugs (9) of the additional arm (5) include two parallel straight sections laterally offset in relation to each other and joined together by an elbow shape, the straight section rooted in the arm (5) being offset toward the longitudinal median plane (P) of the structure.

7. Convertible support according to any of the claims above, **characterized in that** each lateral lug (9) of the arm (5) rests against the corresponding lateral flank (3) through an elongated boss (11) providing linear contact.

8. Convertible support according to any of the claims above, **characterized in that** the fixed arms (4) of the structure (1) are recess-mounted in the lateral flanks (3) of the latter.

9. Convertible support according to any of the claims above, **characterized in that** it includes, on the one hand a structure (1) with four fixed arms (4) arranged along the longitudinal edges of an isosceles trapeze-type rectangular prism, and on the other hand an additional arm (5).

## Patentansprüche

1. Plattenhalter, der wandlungsfähig ist und mindestens zwei Arten von Platten (2) aufnehmen kann, welche sich hinsichtlich der Abmessungen der Platten unterscheiden, wobei er aus einer dreidimensionalen Struktur (1) besteht, die ein Stauvolumen begrenzt, in welchem die Platten (2) angeordnet werden, wobei das Volumen eine mittige geometrische Längsachse (AA') besitzt, die in der mittigen geometrischen Längsebene P der Struktur enthalten ist, wobei die Struktur zwei flächige Seitenstücke (3), die rechtwinklig zur geometrischen Mittelachse sind, aufweist, sowie mindestens zwei feste Holme (4), die parallel zur geometrischen Mittelachse (AA') sind, auf steife Weise an den flächigen Seitenstücken (3) befestigt sind und mit Einkerbungen (41) versehen sind, welche zum Stauvolumen weisen, und wobei die verschiedenen Einkerbungen (41) gemäß geometrischen Ebenen angeordnet sind, die parallel sind, in konstanten Abständen aufeinanderfolgen und rechtwinklig zur mittigen Längsachse des Stauvolumens sind, wobei der Halter weiterhin mit mindestens einem zusätzlichen Holm (5) versehen ist, der parallel zur geometrischen Achse (AA') des Stauvolumens ist, wobei der Holm mit Einkerbungen (51) versehen ist, die zum Stauvolumen weisen, wobei der zusätzliche Holm (5) zum Zwecke der Befestigung mit der dreidimensionalen Struktur (1) zusammenwirkt und derart vorgesehen ist, dass er dem Stauvolumen gegenüberliegt und, in Kombination mit den übrigen Holmen (4), den Verbleib der Platten im Stauvolumen sicherstellt, wobei der normale Abstand zwischen diesem zusätzlichen Holm (5) und der geometrischen Längsachse eines beliebigen festen Holms (4) eingestellt werden kann, um den Halter an die Abmessungen der aufnehmenden Platten (2) anzupassen, und wobei der Holm (5) auf abnehmbare Weise an der Struktur (1) befestigt ist, und dass die Struktur (1) mindestens zwei erste Paare von Befestigungsorganen (6, 7) aufweist, wobei die Organe jedes der ersten Paare voneinander entfernt sind und an einer geometrischen Befestigungsachse ausgerichtet sind, die parallel zur mittigen geometrischen Längsachse (AA') des Stauvolumens ist, wobei der normale Abstand zwischen der geometrischen Befestigungsachse jedes Paares von Befestigungsorganen (6, 7) und der geometrischen Längsachse eines beliebigen festen Holms (4) bei jedem der Paare von Befestigungsorganen unterschiedlich ist, und dass der zusätzliche Holm (5) mindestens ein zweites Paar von Befestigungsorganen (8) aufweist, die voneinander entfernt sind und an einer anderen geometrischen Befestigungsachse ausgerichtet sind, welche parallel zur mittigen geometrischen Längsachse (AA') des Stauvolumens ist, wobei die Befestigungsorgane (8) des zweiten Paares die Koppelstücke zu den Befestigungsorganen (6, 7) der beiden ersten Paare sind und das zweite Paar von Befestigungsorganen (8) dafür vorgesehen ist, zu Befestigungszwecken mit einem der beiden ersten Paare von Befestigungsorganen (6, 7) zusammenzuwirken, um den Halter an die Abmessungen der aufzunehmenden Platten (2) anzupassen, wobei die ersten beiden Paare von Befestigungsorganen (6, 7) auf den flächigen Seitenstücken (3) der Struktur (1) eingerichtet sind, wobei jedes flächige Seitenstück (3) eines der Befestigungsorgane (6, 7) der beiden ersten Paare von Befestigungsorganen aufweist, **dadurch gekennzeichnet, dass** der zusätzliche Holm (5), im rechten Winkel zu seiner Längsachse, zwei seitliche Arme (9) umfasst, die elastisch verformbar sind und in einem Abstand vom Holm (5) die Befestigungsorgane des zweiten Paars von Befestigungsorganen (8) tragen.

2. Wandlungsfähiger Halter nach Anspruch 1, **dadurch gekennzeichnet, dass** die beiden ersten Paare von Befestigungsorganen (6, 7) auf den außerhalb des Stauvolumens gelegenen großen Flächen der beiden flächigen Seitenstücke (3) eingerichtet sind und dass die seitlichen Arme (9) des zusätzlichen Holms (5) diesen beiden großen Flächen gegenüberliegen.

3. Wandlungsfähiger Halter nach Anspruch 1 oder Anspruch 2, **dadurch gekennzeichnet, dass** jedes Befestigungsorgan der beiden ersten Paare von Befestigungsorganen 6, 7 aus einem Höcker besteht und dass das Befestigungsorgan (8), mit welchem jeder der seitlichen Arme versehen ist, aus einer Bohrung besteht, die dazu vorgesehen ist, durch eine formschlüssige Steckverbindung mit dem entsprechenden Höcker (6) oder (7) zusammenzuwirken.

4. Wandlungsfähiger Halter nach einem beliebigen der vorhergehenden Ansprüche, **dadurch gekennzeichnet, dass** der zusätzliche Holm (5) derart an der Struktur (1) befestigt ist, dass er, durch eine winkelförmige Schwenkbewegung der mittigen geometrischen Längsebene (P) der Struktur angenähert oder von dieser entfernt werden kann, wobei der Holm (5), durch eine winkelförmige Schwenkbewegung zur Mittelebene (P), zum Stauvolumen hingeklappt wird.

5. Wandlungsfähiger Halter nach Anspruch 4, **dadurch gekennzeichnet, dass** die Auslenkung der Schwenkbewegung des Holms (5) durch Anschläge (10) begrenzt ist, die an der Struktur (1) befestigt sind.

6. Wandlungsfähiger Halter nach einem beliebigen der vorhergehenden Ansprüche, **dadurch gekennzeichnet, dass** die seitlichen Arme (9) des zusätzlichen Holms (5) zwei parallele geradlinige Abschnitte umfassen, die seitlich zueinander versetzt und durch ein ellbogenartiges Stück miteinander verbunden sind, wobei der geradlinige Abschnitt, der am Holm (5) verankert ist, in Richtung der mittleren Längsebene (P) der Struktur versetzt ist.

7. Wandlungsfähiger Halter nach einem beliebigen der vorhergehenden Ansprüche, **dadurch gekennzeichnet, dass** jeder seitliche Arm (9) des Holms (5) mittels eines länglichen Höckers (11), der einen linearen Kontakt sicherstellt, gegen das entsprechende das flächige Seitenstück (3) drückt.

8. Wandlungsfähiger Halter nach einem beliebigen der vorhergehenden Ansprüche, **dadurch gekennzeichnet, dass** die festen Holme (4) der Struktur (1) in die flächigen Seitenstücke (3) der letzteren eingespannt sind.

9. Wandlungsfähiger Halter nach einem beliebigen der vorhergehenden Ansprüche, **dadurch gekennzeichnet, dass** er einerseits eine Struktur (1), die vier feste Holme (4) aufweist, welche entsprechend den Längskanten eines Prismas mit dem Querschnitt eines gleichschenkligen Trapezes angeordnet sind, und andererseits einen zusätzlichen Holm (5) umfasst.
